# EUROPEAN PATENT SPECIFICATION

(11) **EP 3 469 708 B1**
(45) Date of publication and mention of the grant of the patent: **11.08.2021**
(21) Application number: 17731714.6
(22) Date of filing: 09.06.2017
(51) Int. Cl.: H03F 1/52, H03F 1/22, H03F 3/217, H03F 3/72

(54) **CIRCUITS AND OPERATING METHODS THEREOF FOR MONITORING AND PROTECTING A DEVICE**
SCHALTUNGEN UND VERFAHREN ZUM BETRIEB DAVON ZUR ÜBERWACHUNG UND ZUM SCHUTZ EINER VORRICHTUNG
CIRCUITS DE SURVEILLANCE ET DE PROTECTION D'UN DISPOSITIF, ET PROCÉDÉS DE FONCTIONNEMENT DESDITS CIRCUITS

(30) Priority: 14.06.2016 US 201615181866; 14.06.2016 US 201615181841
(43) Date of publication of application: 17.04.2019
(73) Proprietor: MACOM Technology Solutions Holdings, Inc., Lowell, Massachusetts 01851 (US)
(72) Inventor: BAZZANI, Cristiano, Irvine CA 92606 (US); MCCANN, Damian, Rossmoor CA 90720 (US)
(74) Representative: Cabinet Beaumont
(86) International application number: PCT/US2017/036717
(87) International publication number: WO 2017/218327

(56) References cited:
- US-A1- 2011 025 422
- US-B1- 8 847 688
- US-B2- 7 268 621
- KOYAMA DANIEL ET AL: "Implications of using kW-level GaN transistors in radar and avionic systems", 2015 IEEE INTERNATIONAL CONFERENCE ON MICROWAVES, COMMUNICATIONS, ANTENNAS AND ELECTRONIC SYSTEMS (COMCAS), IEEE, 2 November 2015 (2015-11-02), pages 1-4, XP032834889, DOI: 10.1109/COMCAS.2015.7360465 [retrieved on 2015-12-17]

## Description

### BACKGROUND

### Technical Field

The technology relates to circuits to safeguard a device, such as a gallium nitride (GaN) device, from operating conditions that can damage or destroy the device, and corresponding methods.

### Discussion of the Related Art

GaN semiconductor material has received appreciable attention in recent years because of its desirable electronic and electro-optical properties. GaN has a wide, direct bandgap of about 3.4 eV. Because of its wide bandgap, GaN is more resistant to avalanche breakdown and has a higher intrinsic field strength compared to more common semiconductor materials, such as silicon and gallium arsenide. In addition, GaN is able to maintain its electrical performance at higher temperatures as compared to other semiconductors, such as silicon or gallium arsenide. GaN also has a higher carrier saturation velocity compared to silicon. Additionally, GaN has a Wurtzite crystal structure, is a hard material, has a high thermal conductivity, and has a much higher melting point than other conventional semiconductors such as silicon, germanium, and gallium arsenide. Accordingly, GaN is useful for high-speed, high-voltage, and high-power applications. For example, GaN materials may be used as active circuit components in semiconductor amplifiers for radio-frequency (RF) communications, radar, and microwave applications.

The publication by Daniel Koyama et al. entitled "Implications of using kW-level GaN transistors in radar and avionics systems", 2015 IEEE International Conference on Microwaves, Communications, Antennas and Electronic Systems (COMCAS), IEEE, 2 November 2015, pages 1-4, relates to GaN transistors in radar and avionics systems.

US 8,344,806 relates to a power amplifier with power feedback.

US 2011/0025422 discloses a bias control circuit for an amplifying transistor which comprises a further transistor and a current sense resistance coupled in series with the amplifying transistor.

### SUMMARY

According to a first aspect of the invention, an amplifier system for providing an output signal to a load is provided as defined in independent claim 1. The system includes a first transistor having a drain terminal constructed to provide the output signal to the load and a gate terminal constructed to receive an input signal, a second transistor coupled in series with the first transistor and having a gate terminal, a current sensing circuit coupled to the first transistor and constructed to measure a magnitude of a current in the first transistor, a feedback circuit coupled to the current sensing circuit and constructed to generate a feedback signal indicative of whether the magnitude of the current in the first transistor is above a threshold, and a driver circuit coupled to the feedback circuit and the gate terminal of each of the first and second transistors. The driver circuit is constructed to apply a voltage to the gate terminal of the first transistor and reduce the magnitude of the current in the first transistor by adjusting a gate voltage of the second transistor responsive to the feedback signal indicating that the magnitude of the current in the first transistor is above the threshold.

In one embodiment, the threshold is a configurable threshold. In one embodiment, the first transistor is a gallium nitride (GaN) transistor and the second transistor is a metal-oxide-semiconductor field-effect transistor (MOSFET). In one embodiment, the driver circuit is a GaN sequencer and is further constructed to apply the bias voltage to the gate terminal of the GaN transistor before turning on the MOSFET.

In one embodiment, the current sense circuit includes a current sense resistance coupled in series with the first transistor, a first level-shifter coupled to a first terminal of the current sense resistance, and a second level-shifter coupled to a second terminal of the current sense resistance. In one embodiment, the feedback circuit includes a difference detector constructed to compare a voltage signal indicative the magnitude of the current in the first transistor with a reference voltage that defines the threshold and generate the feedback signal based on the comparison. In one embodiment, the feedback circuit further includes a programmable voltage source constructed to generate the reference voltage and provide the reference voltage to the difference detector.

In one embodiment, the second transistor has a drain terminal coupled to a source terminal of the first transistor. In one embodiment, the system further includes a third transistor having a gate terminal coupled to the driver circuit and a drain terminal coupled to the drain terminal of the second transistor. In one embodiment, the driver circuit is constructed to reduce the magnitude of the current in the first transistor by adjusting a gate voltage of each of the second and third transistors.

According to at least one aspect, a circuit for protecting a gallium nitride (GaN) transistor is provided. The circuit includes a current sensing circuit to measure a magnitude of a current in the GaN transistor, a feedback circuit coupled to the current sensing circuit and constructed to generate a feedback signal indicative of whether the magnitude of the current in the GaN transistor is above a threshold, and a driver circuit constructed to couple to a gate terminal of the GaN transistor and a gate terminal of a transistor coupled in series with the GaN transistor. The driver circuit may be further constructed to receive the feedback signal, apply a bias voltage to the GaN transistor, and reduce the magnitude of the current in the GaN transistor by adjusting a gate voltage of the transistor coupled in series with the GaN transistor responsive to the feedback signal indicating that the magnitude of the current is above the threshold.

In one embodiment, the driver circuit is a GaN sequencer and is further constructed to apply the bias voltage to the gate terminal of the GaN transistor before turning on the transistor coupled in series with the GaN transistor. In one embodiment, the current sense circuit includes a first programmable level-shifter constructed to couple to a first terminal of a current sense resistance and a second programmable level-shifter constructed to couple to a second terminal of the current sense resistance.

In one embodiment, the feedback circuit includes a difference detector constructed to compare a voltage indicative of the magnitude of the current in the first transistor with a reference voltage that defines the threshold and generate the feedback signal based on the comparison. In one embodiment, the feedback circuit further includes a programmable voltage source constructed to generate the reference voltage and provide the reference voltage to the difference detector.

According to a second aspect of the invention, a method for protecting an amplifier that is providing an output signal to a load is provided as defined in independent claim 11. The method includes monitoring a magnitude of a current in a first transistor of the amplifier, determining whether the magnitude of the current in the first transistor is above a threshold by comparing a voltage signal indicative of the magnitude of the current in the first transistor with a reference voltage, and reducing the magnitude of the current in the first transistor by adjusting a gate voltage of a second transistor in the amplifier coupled in series with the first transistor responsive to determining that the magnitude of the current in the first transistor is above the threshold.

In one embodiment, the act of determining whether the magnitude of the current in the first transistor is above the threshold includes determining that the magnitude of the current in the first transistor is below the threshold responsive to the voltage signal being less than the reference voltage and determining that the magnitude of the current in the first transistor is above the threshold responsive to the voltage signal being greater than the reference voltage.

In one embodiment, the act of reducing the magnitude of the current in the first transistor includes turning off the second transistor. In one embodiment, the act of reducing the magnitude of the current in the first transistor includes adjusting a gate voltage of the second transistor and a third transistor, the third transistor being coupled to the second transistor. In one embodiment, the act of reducing the magnitude of the current in the first transistor includes turning off the second transistor and turning on the third transistor.

According to at least one aspect, a system for providing an output signal to a load is provided. The system includes a first transistor having a drain terminal constructed to provide the output to the load and a gate terminal constructed to receive a first input signal, a first circuit coupled to the gate terminal of the first transistor and constructed to apply a bias voltage to the gate terminal of the first transistor, a second circuit coupled to the first transistor and constructed to measure a magnitude of a current in the first transistor, a third circuit coupled to the second circuit and constructed to generate a feedback signal indicative of whether the magnitude of the current in the first transistor is above a threshold, and a fourth circuit coupled to the third circuit and the gate terminal of the first transistor, the fourth circuit being constructed to receive a second input signal and generate the first input signal based on the feedback signal and the second input signal, the first input signal being less than the magnitude of the second input signal responsive to the feedback signal indicating that the magnitude of the current in the first transistor is above the threshold.

In one embodiment, the threshold is a configurable threshold. In one embodiment, the system further includes a second transistor coupled in series with the first transistor, the second transistor having a gate terminal coupled to the driver circuit. In one embodiment, the first transistor is a gallium nitride (GaN) transistor and the second transistor is a metal-oxide-semiconductor field-effect transistor (MOSFET). In one embodiment, the first circuit is a GaN sequencer and is further constructed to apply the bias voltage to the gate terminal of the GaN transistor before turning on the MOSFET.

In one embodiment, the second circuit includes a current sense resistance coupled in series with the first transistor, a first level-shifter coupled to a first terminal of the current sense resistance, and a second level-shifter coupled to a second terminal of the current sense resistance. In one embodiment, the third circuit includes a difference detector constructed to compare the magnitude of the current in the first transistor with a reference voltage that defines threshold and generate the feedback signal based on the comparison. In one embodiment, the third circuit further includes a programmable voltage source constructed to generate the reference voltage and provide the reference voltage to the difference detector. In one embodiment, the first input signal has approximately the same magnitude as the second input signal responsive to the feedback signal indicating that the magnitude of the current in the first transistor is below the threshold.

The foregoing apparatus and method embodiments may be included in any suitable combination with aspects, features, and acts described above or in further detail below. These and other aspects, embodiments, and features of the present teachings can be more fully understood from the following description in conjunction with the accompanying drawings, with a protection scope as defined by the appended set of claims.

### BRIEF DESCRIPTION OF THE DRAWINGS

The skilled artisan will understand that the figures, described herein, are for illustration purposes only. It is to be understood that in some instances various aspects of the embodiments may be shown exaggerated or enlarged to facilitate an understanding of the embodiments. The drawings are not necessarily to scale, emphasis instead being placed upon illustrating the principles of the teachings. In the drawings, like reference characters generally refer to like features, functionally similar and/or structurally similar elements throughout the various figures. A depicted device or circuit may be integrated within a larger circuit.

When referring to the drawings in the following detailed description, spatial references "top," "bottom," "upper," "lower," "vertical," "horizontal," and the like may be used. Such references are used for teaching purposes, and are not intended as absolute references for embodied devices. The terms "on" and "over" are used for ease of explanation relative to the illustrations, and are not intended as absolute directional references. An embodied device may be oriented spatially in any suitable manner that may be different from the orientations shown in the drawings. The drawings are not intended to limit the scope of the present teachings in any way.
**FIGS. 1A-1D** each show a circuit to protect a device from dangerous operating conditions.
**FIG. 2A** shows an amplifier system implementing the protection scheme shown in FIG. 1A;
**FIGS. 2B** **and** **2C** each show an example amplifier system implementing the protection scheme shown in FIG. 1B, according to some embodiments; and
**FIG. 3** shows an example method of operation of a circuit to protect a device from dangerous operating conditions, according to some embodiments.

Features and advantages of the illustrated embodiments will become more apparent from the detailed description set forth below when taken in conjunction with the drawings.

### DETAILED DESCRIPTION

As described above, transistors comprising gallium nitride (GaN) material are useful for high-speed, high-voltage, and high-power applications because of the favorable material properties of GaN. Some applications relating to RF communications, radar, and microwaves can place demanding performance requirements on devices that include GaN transistors. For example, some applications may require high-power transistors capable of amplifying signals to power levels between approximately 50 Watts and approximately 200 Watts.

The favorable properties of GaN transistors also come with new limitations relative to silicon based transistors. For example, the gate-to-source breakdown voltage of a GaN transistor may decrease as the temperature of the GaN transistor increases. The temperature of the GaN transistor may rise because of increases in the magnitude of the current in the GaN transistor caused by operating condition changes. The lower gate-to-source breakdown voltage increases the gate-to-source leakage current in the GaN transistor and may lead to the complete failure of the GaN transistor.

The inventors have appreciated that the failure of GaN transistors from excess heat caused by overcurrent conditions can be avoided by quickly reducing the magnitude of the current in the GaN transistor. The inventors have conceived and developed various circuits and operating methods thereof to monitor the magnitude of the current in the GaN transistor (or other device) and rapidly reduce the magnitude of the current in the GaN transistor when the GaN transistor is heating up. In some embodiments, these circuits maintain the temperature of a GaN transistor within an appropriate range by monitoring the magnitude of the current in the GaN transistor and reducing the magnitude of the current in the GaN transistor and/or shutting down the GaN transistor when the magnitude of the current is outside an appropriate range (and/or above a threshold). The circuitry to monitor and/or control the magnitude of the current in the GaN transistor may utilize complementary metal-oxide-semiconductor (CMOS) devices to advantageously react quickly (e.g., within three microseconds) to shut down the GaN transistor once an unsafe operation condition is detected. It should be appreciated that the circuits and associated methods disclosed herein may be readily applied to protect devices other than GaN transistors.

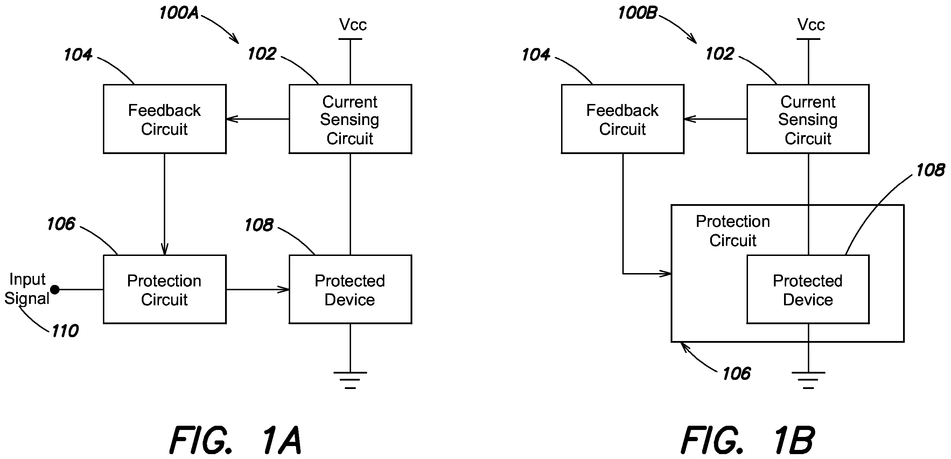

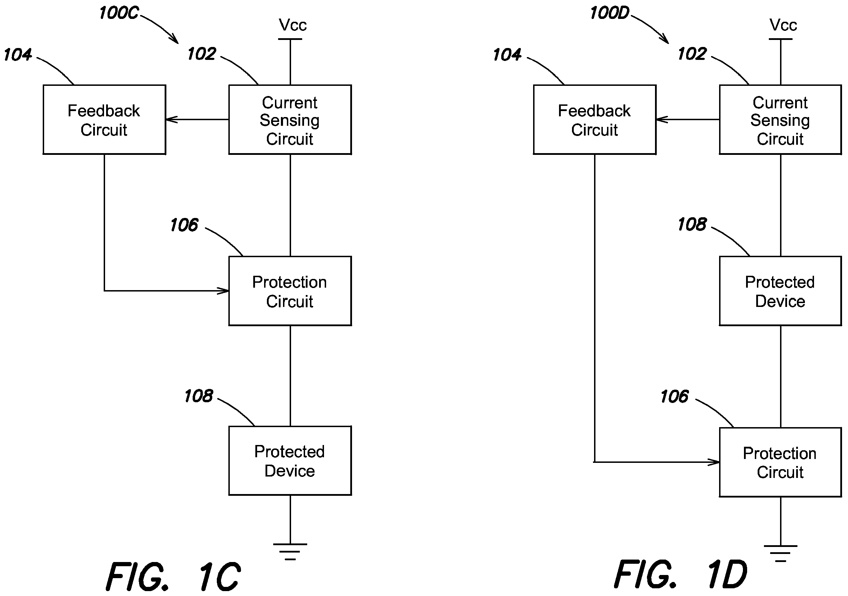

A circuit for protecting a device, such as a GaN transistor, is depicted in FIG. 1A. The circuit 100A includes various components to monitor a magnitude of the current in a protected device 108 and reduce the magnitude of the current in the protected device 108 when the protected device 108 is operating outside a safe range (e.g., above a current threshold). By reducing the magnitude of the current in the protected device 108 during operating conditions that are hazardous to the protected device 108, the lifespan of the protected device 108 may be increased.

The circuit 100A includes a current sensing circuit 102 coupled between the supply voltage Vcc and the protected device 108. The current sensing circuit 102 is constructed to measure an amount of the current in a protected device 108. The current sensing circuit 102 may measure the current in the protected device 108 by any of a variety of methods. For example, the current sensing circuit 102 may include a current sense resistance coupled in series with the protected device 108 and measure a voltage drop across the current sense resistance to determine the magnitude of the current in the protected device 108.

A feedback circuit 104 is coupled to the current sensing circuit 102 and is constructed to receive a signal indicative of the magnitude of the current in the protected device 108 and determine whether the protected device 108 is operating within an appropriate range and/or above a threshold based on the magnitude of the current in the protected device 108. For example, the feedback circuit 104 may be constructed to compare the magnitude of the current in the protected device 108 with a current threshold and generate a feedback signal indicative of whether the magnitude of the current in the protected device 108 is above (or below) the threshold. It should be appreciated that the threshold comparison may be substituted for a range. For example, the feedback circuit 104 may determine whether the magnitude of the current in the protected device 108 is within either a safe range or a hazardous range.

The feedback signal generated by the feedback circuit 104 is provided to a protection circuit 106. The protection circuit 106 reduces the magnitude of the current in the protected device 108 and/or shuts down the protected device 108 responsive to the feedback signal indicating that the protected device 108 is operating outside of a safe range (e.g., above a current threshold). Otherwise, the protection circuit 106 allows the protected device 108 to continue operating without interruption.

The protection circuit 106 may reduce the current in the protected device 108 and/or shut down the protected device 108 by any of a variety of methods. The particular method employed may vary depending upon the location of the protection circuit 106 relative to the protected device 108. As shown in FIG. 1A for example, the protection circuit 106 is coupled to the protected device 108 and a device providing the input signal 110 (not illustrated) for the protected device 108. In this example, the protection circuit 106 may be constructed to reduce the magnitude of the current in the protected device 108 by attenuating the input signal 110 before providing the input signal 110 to the protected device 108. The protection circuit 106 may completely attenuate a magnitude of the voltage of the input signal 110 to zero responsive to any deviation from the safe range or gradually attenuate the magnitude of the voltage of the input signal 110 proportionally to the amount of deviation from the safe range. For example, the feedback signal from the feedback circuit 104 may indicate that the protected device 108 is only 5% over a threshold and the protection circuit 106 may reduce a magnitude of the input signal 110 by 20%. In this example, the protection circuit 106 may apply larger amounts of attenuation to the input signal 110 for larger deviations from the threshold. The feedback circuit 104 may also continually monitor feedback signal and further reduce the magnitude of the input signal 110 if the magnitude of the current in the protected device 108 does not fall below the threshold within a predetermined period of time.

The protection circuit 106 may be integrated with the protected device 108 and/or circuitry constructed to control the protected device 108. Such an example circuit is illustrated by circuit 100B in FIG. 1B. In circuit 100B, the protection circuit 106 may directly control the protected device 108 and/or devices proximate the protected device 108. For example, the protected device 108 may be a GaN transistor in an amplifier and the protection circuit 106 may control the GaN transistor in addition to a metal-oxide-semiconductor field-effect transistor (MOSFET) coupled in series with the GaN transistor. In this example, the protection circuit 106 may reduce the magnitude of the current in the GaN transistor by turning off the MOSFET that is coupled in series with the GaN transistor.

It should be appreciated that the protection circuit 106 may be placed in other locations relative to the protected device 108. As shown in FIG. 1C, the protection circuit 106 may be coupled between the current sensing circuit 102 and the protected device 108. The protection circuit 106 may reduce the magnitude of the current in the protected device 108 by turning off a transistor coupled in series with the protected device 108. By turning off a transistor coupled in series with the protected device 108, the total impedance between the supply voltage Vcc and ground is significantly increased and the magnitude of the current in the protected device 108 is reduced.

As shown in FIG. ID, the protection circuit 106 may also be coupled between the protected device 108 and ground instead of between the current sensing circuit 102 and the protected device 108. The protection circuit 106 in FIG. ID may operate similarly to the protection circuit 106 described above in FIG. 1C. For example, the protection circuit 106 may reduce the magnitude of the current in the protected device 108 by turning off a transistor coupled in series with the protected device 108.

The feedback circuit 104 and/or the protection circuit 106 shown in FIGS. 1A-1D may be advantageously constructed from devices with a quick reaction time to increase the speed at which the circuits 100A-100D can react to changes in the magnitude of current. CMOS devices, for example, may have a propagation delay that is very small (e.g., 10 nanoseconds). Thereby, constructing the feedback circuit 104 and/or the protection circuit 106 from CMOS devices may yield fast reaction times (e.g., less than 1 microsecond) between the magnitude of current in the protected device 108 rising above a threshold and the magnitude of current in the protected device 108 being reduced below the threshold. It should be appreciated that the feedback circuit 104 and/or the protection circuit 106 may be constructed from devices other than CMOS devices.

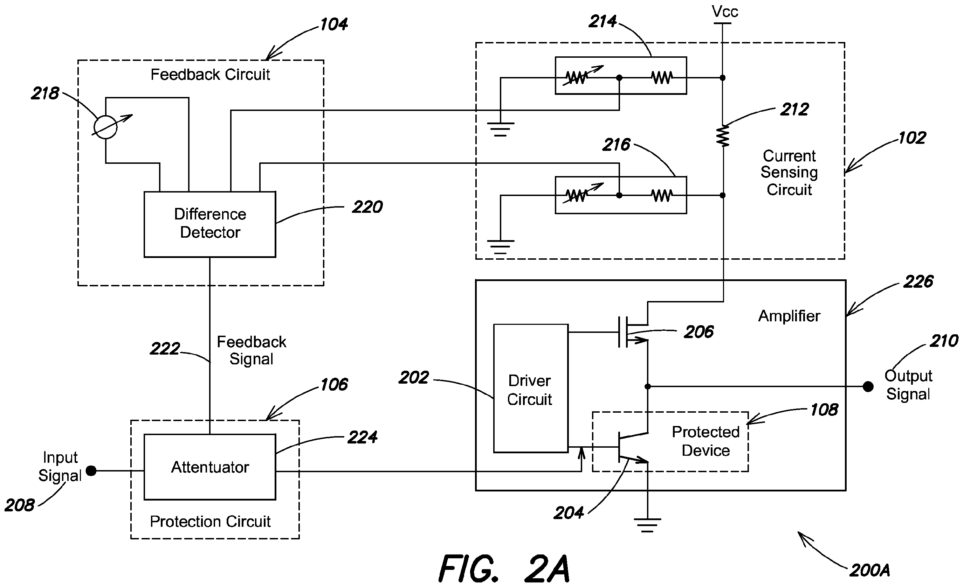

As discussed above, various protection schemes may be employed to safeguard a particular device, such as a GaN transistor, from dangerous operating conditions. These protection schemes may be implemented in any of a variety of systems including, for example, amplifier systems. FIG. 2A illustrates such an amplifier system 200A that implements the protection scheme shown in FIG. 1A above.

The amplifier system 200A includes an amplifier 226 constructed to receive and amplify the input signal 208 to generate the output signal 210. The amplifier 226 includes a first transistor 204 that performs the signal amplification and is also designated as the protected device 108. The amplifier system 200A protects the first transistor 204 by monitoring a magnitude of the current in the first transistor 204 and attenuating the input signal 208 when the first transistor 204 is operating in dangerous conditions. The first transistor 204 receives the input signal 208 at a gate terminal and provides the output signal 210 at a drain terminal. As shown, a source terminal of the first transistor 204 is connected to ground. A driver circuit 202 applies a bias voltage to the gate terminal first transistor 204 and also controls the operation of a second transistor 206 coupled in series with the first transistor 204. The second transistor 206 has a drain terminal coupled to the current sense resistor 212 and a source terminal coupled to the drain terminal of the first transistor 204.

It should be appreciated that the bias voltage from the driver circuit 202 and the input signal 208 may be combined by a combiner circuit (not illustrated) coupled between the driver circuit 202 and the gate terminal of the first transistor 204. For example, the combiner circuit may include an inductor coupled between the driver circuit 202 and the gate terminal of the first transistor 204 to pass the bias voltage and block higher frequencies in addition to a capacitor coupled between the gate terminal of the first transistor 204 and the protection circuit 106 to pass the input signal 208 and block lower frequencies.

As shown in FIG. 2A, the current sensing circuit 102 includes a current sense resistance 212 coupled between the supply voltage Vcc and the drain terminal of the second transistor 206. The current sense resistance 212 may be selected such that the voltage drop across the current sense resistance 212 is small to minimize the excess power dissipation caused by an additional impedance coupled between the supply voltage Vcc and ground. For example, the supply voltage Vcc may be between 30 and 50 Volts and the voltage drop across the current sense resistance 212 may be 1 Volt.

The current sense circuit 102 shown in FIG. 2A includes a first programmable level shifter coupled to a first terminal of the current sense resistance 212 and a second programmable level shifter coupled to a second terminal of the current sense resistance 212. The first and second programmable level shifters 214 and 216, respectively, may reduce a magnitude of the voltage at the ends of the current sense resistance 212 to a suitable range for the feedback circuit 104. For example, the programmable level shifters 214 and 216 may reduce a magnitude of the voltages to between 25 and 50 millivolts (mV). The impedance of the programmable level shifts 214 and 216 may be high to reduce the power losses. For example, the supply voltage Vcc may be between 30 and 50 Volts and the impedance of the programmable level shifters 214 and 216 may be at least 100,000 Ohms. It should be appreciated that various alternations may be made to the programmable level shifters 214 and 216. For example, the variable impedances in the programmable level shifters 214 and 216 may be replaced with and/or programmable current sources. In another example, the programmable level shifters 214 and 216 may be replaced by fixed level shifters by replacing the variable impendence coupled to ground with a fixed impendence and/or a fixed current source. Further, the current sensing circuit 102 may include an amplification stage coupled to the programmable level shifters 214 and 216 to amplify the signal from the programmable level shifters 214 and 216.

The voltage across the two outputs of the programmable level shifters 214 and 216 is indicative of the magnitude of the current in the first transistor 204 and may be provided to the feedback circuit 104. As shown in FIG. 2A, the feedback circuit 104 includes a difference detector 220 coupled to the programmable level shifters 214 and 216 and a programmable reference generator 218 that generates a voltage reference indicative of a maximum current threshold. The difference detector 220 is constructed to compare the voltage reference from the programmable reference generator 218 with the voltage from programmable level shifters 214 and 216. Thereby, the difference detector 220 compares the magnitude of the current in the first transistor 204 with a threshold set by the programmable reference generator 218. The programmability of the programmable reference generator 218 may provide flexibility allowing, for example, the re-use of the same circuitry for different protected devices 108 with different sensitivities to current.

The feedback signal 222 is indicative of whether the magnitude of the current in the first transistor 204 is above the threshold set by the programmable reference generator 218. For example, the difference detector 220 may indicate via the feedback signal 222 that the magnitude of the current in the first transistor 204 is above the threshold responsive to the voltage from the programmable level shifters 214 and 216 being greater than the reference voltage from the programmable reference generator 218.

In some embodiments, the feedback signal 222 generated by the difference detector 220 may be an analog signal. For example, the difference detector 220 may be implemented as a difference amplifier and the feedback signal 222 provided by the difference amplifier may be indicative of a difference between the voltage from the programmable level shifters 214 and 216 and the voltage from the programmable reference generator 218.

It should be appreciated that the feedback circuit 104 may be constructed to compare the magnitude of the current in the first transistor 204 to multiple thresholds and/or ranges depending upon the particular implementation. For example, the difference detector 220 may receive multiple reference voltages and compare the voltage from the programmable level shifters 214 and 216 to each of the reference voltages. In this example, the difference detector 220 may identify the closest reference voltage that is above the voltage from the programmable level shifters 214 and 216 and the closest reference voltage that is below the voltage from the programmable level shifters 214 and 216 to identify a range that the magnitude of the current falls within. Based on which range that the magnitude of the current falls within, the protection circuit 106 may take appropriate action to reduce the magnitude of the current in the first transistor 204 or allow the first transistor 204 to continue operating without interruption.

As shown in FIG. 2A, the protection circuit 106 receives the input signal 208 and attenuates the input signal 208 based on the feedback signal 222 before providing the input signal 208 to the gate terminal of the first transistor 204. The attenuation of the input signal 208 in the protection circuit 106 may be performed by an attenuator 224. The attenuator 224 may attenuate the input signal 208 to (or near) zero responsive to the feedback signal 222 indicating that the magnitude of the current in the first transistor 204 is above the threshold. Alternatively, the attenuator 224 may apply attenuation to the input signal 208 gradually as the current in the first transistor 204 exceeds a threshold and/or particular thresholds in a set of thresholds. For example, the feedback signal 222 may indicate that the magnitude of the current in the first transistor 204 is between the two lowest thresholds (e.g., in a first range) and attenuator 224 may slightly attenuate the input signal 208. The attenuator 224 may apply larger amounts of attenuation when the feedback signal 222 indicates that the magnitude of the current in the first transistor 204 is above the two lowest thresholds (e.g., in a second range). In another example, the feedback signal 222 may be an analog signal that indicates the deviation between the magnitude of current in the first transistor 204 and a threshold. In this example, the magnitude of attenuation applied by attenuator 224 may be proportional to the magnitude of the deviation indicated by the feedback signal 222. The attenuator 224 may also modify the amount of attenuation based on the response exhibited by the first transistor 204. For example, the attenuator 224 may first apply a small level of attenuation to the input signal 208 responsive to the magnitude of the current being above the lowest threshold and subsequently increase the amount of attenuation applied to the input signal 208 responsive to the magnitude of the current remaining above the lowest threshold.

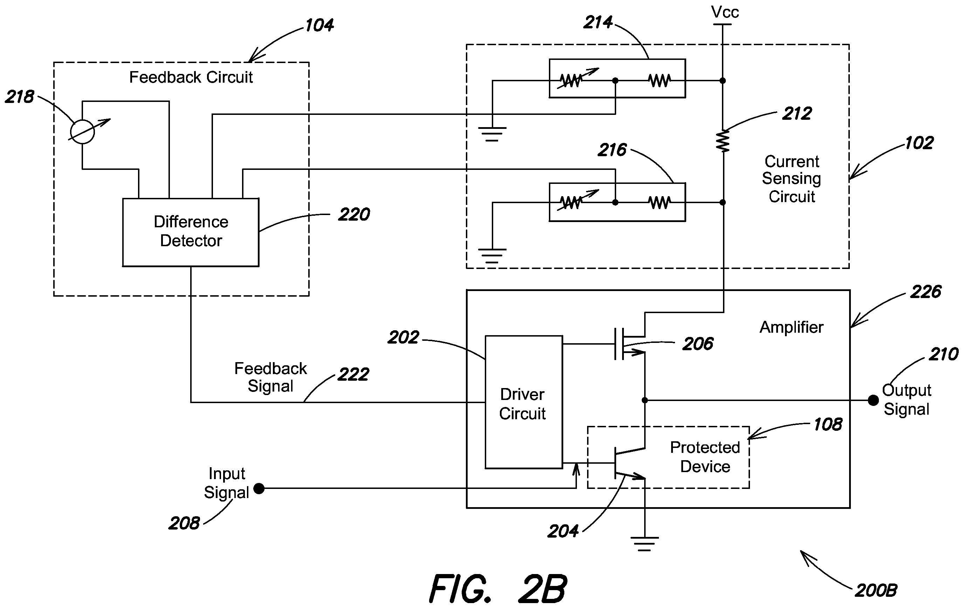

As discussed above with reference to FIG. 1B, the functionality of the protection circuit 106 may be integrated with the protected device 108 and/or integrated with the circuitry that controls operation of the protected device 108. FIG. 2B illustrates such an example amplifier system 200B with the functionality of the protection circuit integrated into the amplifier 226. Integrating the functionality of the protection circuit into the amplifier may advantageously simplify the construction of the amplifier system 200B by leveraging existing devices to perform various functions performed by the protection circuit. Thereby, the cost and complexity of manufacturing the amplifier system may be reduced.

As shown in FIG. 2B, the feedback signal 222 from the feedback circuit 104 is provided to the driver circuit 202 of the amplifier 226. In this implementation, the driver circuit 202 is constructed to control operation of the second transistor 206 based on the feedback signal 222. The feedback signal 222 may indicate that the magnitude of the current in the first transistor 204 is above the threshold and the driver circuit 202 may turn off the second transistor 206 to reduce the magnitude of the current in the first transistor. If the feedback signal 222 indicates that the magnitude of the current in the first transistor 204 is below the threshold, the driver circuit 202 may turn on the second transistor 206 (or keep the second transistor 206 on). Thereby, the functionality of the protection circuit is integrated into existing components of the amplifier 226 (e.g., the driver circuit 202 and the second transistor 206).

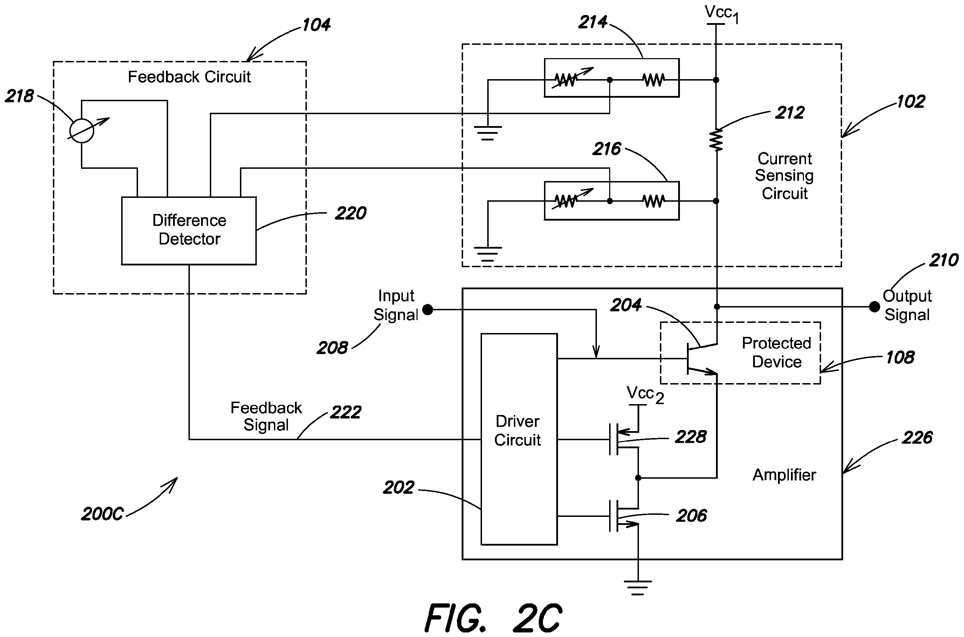

FIG. 2C illustrates another example amplifier system 200C with the functionality of the protection circuit integrated into the amplifier 226. As shown in FIG. 2C, the drain terminal of the second transistor 206 is coupled to the source terminal of the first transistor 204 instead of the drain terminal of the first transistor 204 as shown in FIGS. 2A and 2B. The amplifier 226 shown in FIG. 2C further includes a third transistor 228 coupled in series with the second transistor 206. The third transistor 228 has a source terminal coupled to a second supply voltage Vcc₂, a gate terminal coupled to the driver circuit 202, and a drain terminal coupled to the drain terminal of the second transistor 206. In this implementation, the driver circuit 202 is constructed to reduce the magnitude of the current in the first transistor 204 by simultaneously turning off the second transistor 206 and turning on the third transistor 228 to increase the voltage level at the source terminal of the first transistor 204. For example, turning off the second transistor 206 and turning on the third transistor 228 raises the voltage level at the source terminal of the first transistor 204 from ground to Vcc₂. By increasing the voltage at the source terminal of the first transistor 204, both the voltage drop across the first transistor 204 and the magnitude of the current in the first transistor 204 are reduced. The driver circuit 202 may turn on the second transistor 206 and turn off the third transistor 228 during normal operation when the magnitude of the current in the first transistor 204 is below the threshold.

As shown in FIG. 2C, the third transistor 228 may be a p-type transistor while the second transistor 206 may be an n-type transistor. Implementing the second and third transistors 206 and 228, respectively, as different types may allow the driver circuit to apply a similar (or same) control signal to both transistors and achieve the desired modes of operation. For example, a first control signal may be sent to the second and third transistors 206 and 228, respectively, to turn off the second transistor 206 and turn on the third transistor 228 to increase the voltage applied to the source terminal of the first transistor 204. Conversely, a second control signal may be sent to the second and third transistors 206 and 228, respectively, to turn on the second transistor 206 and turn off the third transistor 228 to ground the source terminal of the first transistor 204.

In some embodiments, the amplifier 226 shown in each of FIGS. 2A-2C includes a GaN transistor. For example, the first transistor 204 may be a GaN transistor and the second transistor 206 may be formed from a different type of semiconductor, such as a silicon metal-oxide-semiconductor field-effect transistor (MOSFET). In these embodiments, the driver circuit 202 may be a GaN sequencer that is constructed to apply the bias voltage to the GaN transistor before turning on the MOSFET to avoid damage to the GaN transistor. In the implementations shown in FIG. 2B and 2C, the GaN sequencer may control the second transistor 206 to both properly sequence the GaN transistor and also reduce the current in the GaN transistor responsive to the magnitude of the current in the GaN transistor exceeding a threshold.

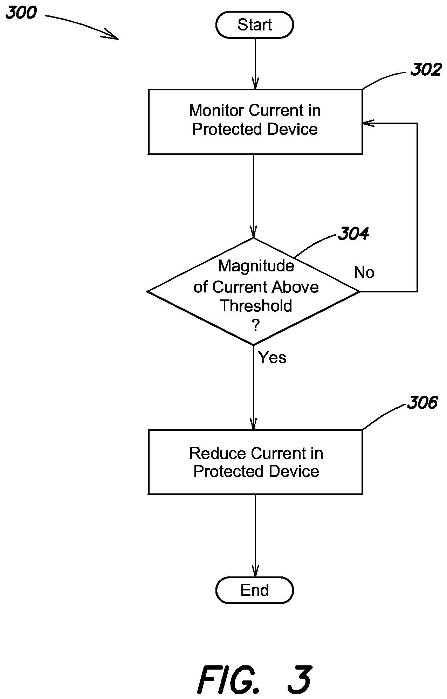

As discussed above, various circuits may be designed to protect a device, such as a GaN transistor, from damage caused by hazardous operating conditions. FIG. 3 illustrates an example method of operation 300 for these circuits according to some embodiments. The method 300 protects a device by monitoring a magnitude of the current in a protected device and determining whether the magnitude of the current in the protected device is above a threshold. If the magnitude of the current in the protected device is above the threshold, the magnitude of the current in the protected device is reduced. Otherwise, the protected device is allowed to continue operating without interruption.

In act 302, the circuit monitors the magnitude of the current in the protected device. The protected device may include a GaN transistor or other device that is sensitive to heat and/or current. The circuit may monitor the current in the protected device by any of a variety of methods. For example, the circuit may include a current sense resistance coupled in series with the protected device and the circuit may measure a voltage drop across the current sense resistance to determine a magnitude of the current in the protected device.

In act 304, the circuit determines whether the magnitude of the current in the protected device is above a threshold. The circuit may include, for example, a difference detector that is constructed to compare a voltage reference that is indicative of the threshold with a voltage signal indicative of the magnitude of the current in the protected device. In this example, the circuit may indicate that the magnitude of the current in the protected device is above the threshold responsive to the voltage signal indicative of the magnitude of the current in the protected device being larger than the voltage reference. Conversely, the circuit may indicate that the magnitude of the current in the protected device is below the threshold responsive to the voltage signal indicative of the magnitude of the current in the protected device being less than the voltage reference. If the magnitude of the current in the protected device is above the threshold, the circuit proceeds to act 306 to reduce the current in the protected device. Otherwise, the circuit returns to act 302 and continues to monitor the magnitude of the current in the protected device.

The circuit may employ any of a variety of methods in act 306 to reduce the magnitude of the current in the protected device. For example, the circuit may turn off a transistor coupled in series with the protected device and/or attenuate an input signal to the protected device. In examples where the protected device is a transistor, the circuit may also raise a voltage level at a source terminal of the transistor to both reduce a voltage drop across the transistor and reduce a magnitude of the current in the transistor.

It should be appreciated that the circuit may compare the magnitude of the current in the protected device with multiple thresholds or ranges in act 304. For example, the circuit may determine whether the magnitude of the current in the protected device is within a first range that is safe for the protected device or a second higher range that is unsafe for the protected device. In this example, the circuit may proceed to act 306 responsive to the protected device operating in the second higher range. Otherwise, the circuit may return to act 302 and continue monitoring the protected device.

The terms "approximately" and "about" may be used to mean within ±20% of a target dimension in some embodiments, within ±10% of a target dimension in some embodiments, within ±5% of a target dimension in some embodiments, and yet within ±2% of a target dimension in some embodiments. The terms "approximately" and "about" may include the target dimension.

The technology described herein may be embodied as a method, of which at least some acts have been described. The acts performed as part of the method may be ordered in any suitable way. Accordingly, embodiments may be constructed in which acts are performed in an order different than described, which may include performing some acts simultaneously, even though described as sequential acts in illustrative embodiments. Additionally, a method may include more acts than those described, in some embodiments, and fewer acts than those described in other embodiments.

Having thus described at least one illustrative embodiment of the invention, various alterations, modifications, and improvements will readily occur to those skilled in the art. Accordingly, the foregoing description is by way of example only and is not intended as limiting. The invention is limited only as defined in the following claims.

## Claims

1. An amplifier system (200B, 200C) for providing an output signal to a load, the system comprising:
an amplifier (226) including a first transistor (204) having a drain terminal and a gate terminal, wherein the first transistor (204) is constructed to receive an input signal at the gate terminal, to amplify the input signal as an amplified input signal and to provide the output signal to the load at the drain terminal as the amplified input signal; the amplifier (226) further including
a second transistor (206) coupled in series with the first transistor (204) with a direct connection either to the drain or to the source of the first transistor (204), and having a gate terminal;
the amplifier system (200B, 200C) further comprising:
a current sensing circuit (102) including a current sense resistance (212) coupled in series to the first transistor (204) via the drain terminal of the first transistor (204) and constructed to measure a magnitude of a current in the first transistor (204);
a feedback circuit (104) coupled to the current sensing circuit (102) and constructed to generate a feedback signal indicative of whether the magnitude of the current in the first transistor (204) is above a threshold; and
a driver circuit (202) coupled to the feedback circuit and the gate terminal of each of the first and second transistors, the driver circuit (202) constructed to apply a voltage to the gate terminal of the first transistor (204) and reduce the magnitude of the current in the first transistor (204) by adjusting a gate voltage of the second transistor (206) responsive to the feedback signal indicating that the magnitude of the current in the first transistor (204) is above the threshold.

2. The system of claim 1, wherein the threshold is a configurable threshold.

3. The system of claim 1, wherein the first transistor (204) is a gallium nitride, GaN, transistor and the second transistor (206) is a metal-oxide-semiconductor field-effect transistor, MOSFET.

4. The system of claim 3, wherein the driver circuit (202) is a GaN sequencer and is further constructed to apply the bias voltage to the gate terminal of the GaN transistor (204) before turning on the MOSFET (206).

5. The system of claim 1, wherein the current sensing circuit (102) includes a first level-shifter (214) coupled to a first terminal of the current sense resistance (212) and a second level-shifter (216) coupled to a second terminal of the current sense resistance (212).

6. The system of any one of claims 1 through claim 5, wherein the feedback circuit (104) includes a difference detector (220) constructed to compare a voltage signal indicative the magnitude of the current in the first transistor (204) with a reference voltage that defines the threshold and generate the feedback signal based on the comparison.

7. The system of claim 6, wherein the feedback circuit (104) further includes a programmable voltage source (218) constructed to generate the reference voltage and provide the reference voltage to the difference detector (220).

8. The system of any one of claims 1 through claim 5, wherein the second transistor (206) has a drain terminal coupled to a source terminal of the first transistor (204).

9. The system of claim 8, further comprising a third transistor (228) having a gate terminal coupled to the driver circuit (202) and a drain terminal coupled to the drain terminal of the second transistor (206).

10. The system of claim 9, wherein the driver circuit (202) is constructed to reduce the magnitude of the current in the first transistor (204) by adjusting a gate voltage of each of the second and third transistors (206, 228).

11. A method for protecting an amplifier (226) that is providing an output signal to a load, comprising:
monitoring a magnitude of a current in a first transistor (204) of the amplifier, wherein the first transistor (204) has a drain terminal and a gate terminal, wherein the first transistor (204) is constructed to receive an input signal at the gate terminal, to amplify the input signal as an amplified input signal, and to provide the output signal to the load at the drain terminal as the amplified input signal;
the monitoring comprising measuring a voltage drop across a current sense resistance (212) coupled in series to the first transistor (204) via the drain terminal of the first transistor (204);
determining whether the magnitude of the current in the first transistor (204) is above a threshold by comparing a voltage signal indicative of the magnitude of the current in the first transistor (204) with a reference voltage; and
reducing the magnitude of the current in the first transistor (204) by adjusting a gate voltage of a second transistor (206) in the amplifier (226) coupled in series with the first transistor (204) with a direct connection either to the drain or to the source of the first transistor (204), and responsive to determining that the magnitude of the current in the first transistor (204) is above the threshold.

12. The method of claim 11, wherein determining whether the magnitude of the current in the first transistor (204) is above the threshold includes determining that the magnitude of the current in the first transistor (204) is below the threshold responsive to the voltage signal being less than the reference voltage and determining that the magnitude of the current in the first transistor (204) is above the threshold responsive to the voltage signal being greater than the reference voltage.

13. The method of claim 11 or 12, wherein reducing the magnitude of the current in the first transistor (204) includes turning off the second transistor (206).

14. The method of claim 11 or 12, wherein reducing the magnitude of the current in the first transistor (204) includes adjusting a gate voltage of the second transistor (206) and a third transistor (228), the third transistor being coupled to the second transistor (206).

15. The method of claim 14, wherein reducing the magnitude of the current in the first transistor (204) includes turning off the second transistor (206) and turning on the third transistor (228).

## Patentansprüche

1. Ein Verstärkersystem (200B, 200C) zum Vorsehen eines Ausgangssignals für eine Last, wobei das System Folgendes aufweist:
einen Verstärker (226) aufweisend einen ersten Transistor (204) mit einem Drain-Anschluss und einem Gate-Anschluss, wobei der erste Transistor (204) aufgebaut ist zum Empfangen eines Eingangssignals am Gate-Anschluss, zum Verstärken des Eingangssignals als ein verstärktes Eingangssignal und zum Vorsehen des Ausgangssignals für die Last an dem Drain-Anschluss als das verstärkte Eingangssignal; wobei der Verstärker (226) ferner Folgendes aufweist
einen zweiten Transistor (206), der mit dem ersten Transistor (204) in Reihe geschaltet ist, und zwar direkt verbunden mit dem Drain oder mit der Source des ersten Transistors (204), und der einen Gate-Anschluss aufweist;
wobei das Verstärkersystem (200B, 200C) weiterhin Folgendes aufweist:
eine Stromabfühlschaltung (102) mit einem Stromabfühlwiderstand (212), der über den Drain-Anschluss des ersten Transistors (204) in Reihe mit dem ersten Transistor (204) gekoppelt ist und aufgebaut ist zum Messen einer Größe eines Stroms in dem ersten Transistor (204);
eine Rückkopplungsschaltung (104), die mit der Stromabfühlschaltung (102) gekoppelt und aufgebaut ist zum Erzeugen eines Rückkopplungssignal, das anzeigt, ob die Größe des Stroms in dem ersten Transistor (204) über einem Schwellenwert liegt; und
eine Treiberschaltung (202), die mit der Rückkopplungsschaltung und dem Gate-Anschluss sowohl des ersten als auch des zweiten Transistors gekoppelt ist, wobei die Treiberschaltung (202) aufgebaut ist zum Anlegen einer Spannung an den Gate-Anschluss des ersten Transistors (204) und zum Reduzieren der Größe des Stroms in dem ersten Transistor (204) durch Einstellen einer Gate-Spannung des zweiten Transistors (206) darauf ansprechend, dass das Rückkopplungssignal anzeigt, dass die Größe des Stroms in dem ersten Transistor (204) über dem Schwellenwert liegt.

2. System nach Anspruch 1, wobei der Schwellenwert ein konfigurierbarer Schwellenwert ist.

3. System nach Anspruch 1, wobei der erste Transistor (204) ein Galliumnitrid, GaN-Transistor, und der zweite Transistor (206) ein Metaloxid-Halbleiter-Feldeffekttransistor, MOSFET, ist.

4. System nach Anspruch 3, wobei die Treiberschaltung (202) ein GaN-Sequenzer ist und ferner aufgebaut ist zum Anlegen der Vorspannung an den Gate-Anschluss des GaN-Transistors (204) bevor der MOSFET (206) eingeschaltet wird.

5. System nach Anspruch 1, wobei die Stromabfühlschaltung (102) einen ersten Pegelschieber (214) aufweist, der mit einem ersten Anschluss des Stromabfühlwiderstands (212) gekoppelt ist, und einen zweiten Pegelschieber (216), der mit einem zweiten Anschluss des Stromabfühlwiderstands (212) gekoppelt ist.

6. System nach einem der Ansprüche 1 bis 5, wobei die Rückkopplungsschaltung (104) einen Differenzdetektor (220) aufweist, der aufgebaut ist zum Vergleichen eines die Größe des Stroms in dem ersten Transistor (204) anzeigenden Spannungssignals mit einer Referenzspannung, die den Schwellenwert definiert, und zum Erzeugen des Rückkopplungssignals basierend auf dem Vergleich.

7. System nach Anspruch 6, wobei die Rückkopplungsschaltung (104) ferner eine programmierbare Spannungsquelle (218) aufweist, die aufgebaut ist zum Erzeugen der Referenzspannung und zum Vorsehen der Referenzspannung an den Differenzdetektor (220).

8. Das System nach einem der Ansprüche 1 bis 5, wobei der zweite Transistor (206) einen Drain-Anschluss aufweist, der mit einem Source-Anschluss des ersten Transistors (204) gekoppelt ist.

9. System nach Anspruch 8, ferner aufweisend einen dritten Transistor (228) mit einem Gate-Anschluss, der mit der Treiberschaltung (202) gekoppelt ist und einem Drain-Anschluss, der mit dem Drain-Anschluss des zweiten Transistors (206) gekoppelt ist.

10. System nach Anspruch 9, wobei die Treiberschaltung (202) aufgebaut ist zum Reduzieren der Größe des Stroms in dem ersten Transistor (204) durch Einstellen einer Gate-Spannung sowohl des zweiten als auch des dritten Transistors (206, 228).

11. Verfahren zum Schutz eines Verstärkers (226), der ein Ausgangssignal für eine Last liefert, wobei das Verfahren Folgendes aufweist:
Überwachen einer Größe eines Stroms in einem ersten Transistor (204) des Verstärkers, wobei der erste Transistor (204) einen Drain-Anschluss und einen Gate-Anschluss aufweist, wobei der erste Transistor (204) aufgebaut ist zum Empfangen eines Eingangssignal an dem Gate-Anschluss, zum Verstärken des Eingangssignals als ein verstärktes Eingangssignal und zum Vorsehen des Ausgangssignals für die Last an dem Drain-Anschluss als das verstärkte Eingangssignal;
wobei die Überwachung Folgendes aufweist
Messen eines Spannungsabfalls über einen Stromabfühlwiderstand (212), der über den Drain-Anschluss des ersten Transistors (204) in Reihe mit dem ersten Transistor (204) gekoppelt ist;
Bestimmen, ob die Größe des Stroms in dem ersten Transistor (204) über einem Schwellenwert liegt, durch Vergleichen eines Spannungssignals, das die Größe des Stroms in dem ersten Transistor (204) anzeigt, mit einer Referenzspannung; und
Reduzieren der Größe des Stroms in dem ersten Transistor (204) durch Einstellen einer Gate-Spannung eines zweiten Transistors (206) in dem Verstärker (226), der mit dem ersten Transistor (204) in Reihe geschaltet ist, mit einer direkten Verbindung entweder mit dem Drain oder mit der Source des ersten Transistors (204), und zwar ansprechend auf das Bestimmen, dass die Größe des Stroms in dem ersten Transistor (204) über dem Schwellenwert liegt.

12. Verfahren nach Anspruch 11, wobei das Bestimmen, ob die Größe des Stroms in dem ersten Transistor (204) oberhalb des Schwellenwerts liegt, das Bestimmen einschließt, dass die Größe des Stroms in dem ersten Transistor (204) unterhalb des Schwellenwerts liegt, und zwar ansprechend darauf, dass das Spannungssignal kleiner als die Referenzspannung ist, und das Bestimmen, dass die Größe des Stroms in dem ersten Transistor (204) oberhalb des Schwellenwerts liegt, ansprechend darauf, dass das Spannungssignal größer als die Referenzspannung ist.

13. Verfahren nach Anspruch 11 oder 12, wobei das Reduzieren der Größe des Stroms in dem ersten Transistor (204) das Abschalten des zweiten Transistors (206) aufweist.

14. Verfahren nach Anspruch 11 oder 12, wobei das Reduzieren der Größe des Stroms in dem ersten Transistor (204) das Einstellen einer Gate-Spannung des zweiten Transistors (206) und eines dritten Transistors (228) aufweist, wobei der dritte Transistor mit dem zweiten Transistor (206) gekoppelt ist.

15. Verfahren nach Anspruch 14, wobei das Reduzieren der Größe des Stroms im ersten Transistor (204) das Abschalten des zweiten Transistors (206) und das Einschalten des dritten Transistors (228) aufweist.

## Revendications

1. Système amplificateur (200B, 200C) pour fournir un signal de sortie à une charge, le système comprenant :
un amplificateur (226) comprenant un premier transistor (204) comportant une borne de drain et une borne de grille, le premier transistor (204) étant construit pour recevoir un signal d'entrée sur la borne de grille, pour amplifier le signal d'entrée en un signal d'entrée amplifié et pour fournir le signal de sortie à la charge au niveau de la borne de drain en tant que signal d'entrée amplifié ; l'amplificateur (226) comprenant en outre un deuxième transistor (206) couplé en série avec le premier transistor (204) avec une connexion directe soit au drain soit à la source du premier transistor (204), et comportant une borne de grille ;
le système amplificateur (200B, 200C) comprenant en outre :
un circuit de détection de courant (102) comprenant une résistance de détection de courant (212) couplée en série avec le premier transistor (204) par l'intermédiaire de la borne de drain du premier transistor (204) et construit pour mesurer l'amplitude d'un courant dans le premier transistor (204) ;
un circuit de rétroaction (104) couplé au circuit de détection de courant (102) et construit pour générer un signal de rétroaction indicatif du fait que l'amplitude du courant dans le premier transistor (204) est supérieure à un seuil ; et
un circuit de commande (202) couplé au circuit de rétroaction et à la borne de grille de chacun des premier et deuxième transistors, le circuit de commande (202) étant construit pour appliquer une tension sur la borne de grille du premier transistor (204) et réduire l'amplitude du courant dans le premier transistor (204) en ajustant une tension de grille du deuxième transistor (206) en réponse au fait que le signal de rétroaction indique que l'amplitude du courant dans le premier transistor (204) est supérieure au seuil.

2. Système selon la revendication 1, dans lequel le seuil est un seuil configurable.

3. Système selon la revendication 1, dans lequel le premier transistor (204) est un transistor au nitrure de gallium, GaN, et le deuxième transistor (206) est un transistor métal-oxyde-semi-conducteur à effet de champ, MOSFET.

4. Système selon la revendication 3, dans lequel le circuit de commande (202) est un séquenceur GaN et est en outre construit pour appliquer la tension de polarisation à la borne de grille du transistor GaN (204) avant de mettre à l'état passant le MOSFET (206).

5. Système selon la revendication 1, dans lequel le circuit de détection de courant (102) comprend un premier dispositif de décalage de niveau (214) couplé à une première borne de la résistance de détection de courant (212) et un deuxième dispositif de décalage de niveau (216) couplé à une deuxième borne de la résistance de détection de courant (212).

6. Système selon l'une quelconque des revendications 1 à 5, dans lequel le circuit de rétroaction (104) comprend un détecteur de différence (220) construit pour comparer un signal de tension indicatif de l'amplitude du courant dans le premier transistor (204) à une tension de référence qui définit le seuil et générer le signal de rétroaction sur la base de la comparaison.

7. Système selon la revendication 6, dans lequel le circuit de rétroaction (104) comprend en outre une source de tension programmable (218) construite pour générer la tension de référence et fournir la tension de référence au détecteur de différence (220).

8. Système selon l'une quelconque des revendications 1 à 5, dans lequel le deuxième transistor (206) comporte une borne de drain couplée à une borne de source du premier transistor (204) .

9. Système selon la revendication 8, comprenant en outre un troisième transistor (228) comportant une borne de grille couplée au circuit de commande (202) et une borne de drain couplée à la borne de drain du deuxième transistor (206).

10. Système selon la revendication 9, dans lequel le circuit de commande (202) est construit pour réduire l'amplitude du courant dans le premier transistor (204) en ajustant une tension de grille de chacun des deuxième et troisième transistors (206, 228).

11. Procédé de protection d'un amplificateur (226) qui fournit un signal de sortie à une charge, comprenant :
surveiller l'amplitude d'un courant dans un premier transistor (204) de l'amplificateur, le premier transistor (204) comportant une borne de drain et une borne de grille, le premier transistor (204) étant construit pour recevoir un signal d'entrée sur la borne de grille, pour amplifier le signal d'entrée en un signal d'entrée amplifié, et pour fournir le signal de sortie à la charge au niveau de la borne de drain en tant que signal d'entrée amplifié ;
la surveillance comprenant :
mesurer une chute de tension aux bornes d'une résistance de détection de courant (212) couplée en série avec le premier transistor (204) par l'intermédiaire de la borne de drain du premier transistor (204) ;
déterminer si l'amplitude du courant dans le premier transistor (204) est supérieure à un seuil en comparant un signal de tension indicatif de l'amplitude du courant dans le premier transistor (204) à une tension de référence ; et
réduire l'amplitude du courant dans le premier transistor (204) en ajustant une tension de grille d'un deuxième transistor (206) dans l'amplificateur (226) couplé en série avec le premier transistor (204) avec une connexion directe soit au drain soit à la source du premier transistor (204), et en réponse à une détermination que l'amplitude du courant dans le premier transistor (204) est supérieure au seuil.

12. Procédé selon la revendication 11, dans lequel la détermination si l'amplitude du courant dans le premier transistor (204) est supérieure au seuil comprend la détermination que l'amplitude du courant dans le premier transistor (204) est inférieure au seuil en réponse au fait que le signal de tension est inférieur à la tension de référence et la détermination que l'amplitude du courant dans le premier transistor (204) est supérieure au seuil en réponse au fait que le signal de tension est supérieur à la tension de référence.

13. Procédé selon la revendication 11 ou 12, dans lequel la réduction de l'amplitude du courant dans le premier transistor (204) comprend de mettre à l'état non passant le deuxième transistor (206).

14. Procédé selon la revendication 11 ou 12, dans lequel la réduction de l'amplitude du courant dans le premier transistor (204) comprend l'ajustement d'une tension de grille du deuxième transistor (206) et d'un troisième transistor (228), le troisième transistor étant couplé au deuxième transistor (206).

15. Procédé selon la revendication 14, dans lequel la réduction de l'amplitude du courant dans le premier transistor (204) comprend de mettre à l'état non passant le deuxième transistor (206) et de mettre à l'état passant le troisième transistor (228).
